Europäisches Patentamt

European Patent Office

Office européen des brevets

(11) Veröffentlichungsnummer: **0 128 532**
**A2**

(12) # EUROPÄISCHE PATENTANMELDUNG

(21) Anmeldenummer: **84106500.6**

(22) Anmeldetag: **07.06.84**

(51) Int. Cl.³: **H 03 J 5/24**

(30) Priorität: **11.06.83 DE 3321262**

(43) Veröffentlichungstag der Anmeldung: **19.12.84**
**Patentblatt 84/51**

(84) Benannte Vertragsstaaten: **AT FR GB IT NL**

(71) Anmelder: **TELEFUNKEN electronic GmbH, Theresienstrasse 2, D-7100 Heilbronn (DE)**

(72) Erfinder: **Heigl, Franz, Frühlingsstrasse 12, D-8079 Ochsenfeld (DE)**
Erfinder: **Rehm, Josef, Perusastrasse 32, D-8069 Rohrbach (DE)**

(74) Vertreter: **Maute, Hans-Jürgen, Dipl.-Ing., TELEFUNKEN electronic GmbH Theresienstrasse 2, D-7100 Heilbronn (DE)**

(54) **Abstimmschaltung für die Bereiche UHF- und VHF.**

(57)   Bei einer Abstimmschaltung für die Frequenzbereiche UHF und VHF ist ein nach Art eines lambda-halbe-Resonanzkreises aufgebauter Schwingkreis 4, 5 vorgesehen, bei dem parallel zu einer Abstimmkapazität 8 eine Abgleichspule 9 für das obere Frequenzbandende des UHF-Bereichs über einen Schalter an Masse geschaltet ist. Parallel zum Schalter 11 liegt wenigstens eine Induktivität 12, 13, die bei geöffnetem Schalter 11 die Resonanzfrequenz des Resonanzkreises 4, 5 in den VHF-Bereich schiebt. Um hierbei den durchstimmbaren Frequenzbereich besonders im niedrigsten Frequenzband mit einfachen Maßnahmen zu vergrößern, ist in Serie mit der Induktivität 12, 13 eine weitere Abstimmkapazität 14 geschaltet, die einendig gegen Masse gelegt ist. Die HF-Energie wird bei UHF-Betrieb am Hochpunkt des Resonanzkreises ausgekoppelt und unmittelbar einer UHF-Mischstufe zugeführt. Bei VHF-Betrieb wird die HF-Energie dagegen über der weiteren Abstimmkapazität 14 ausgekoppelt und einer getrennten, fremdgesteuerten VHF-Mischstufe zugeführt. Bei VHF-Betrieb kann dann die UHF-Mischstufe als VHF-Oszillator umgeschaltet werden.

TEG-83/02

16.02.1983
Bt/ub

0128532

TELEFUNKEN electronic GmbH
Frankfurt/Main

### Abstimmschaltung für die Bereiche UHF- und VHF

Die Erfindung betrifft eine Abstimmschaltung gemäß dem Oberbegriff des ersten Patentsanspruchs.

Bei einer bekannten Abstimmschaltung dieser Art (DE-AS
25 03 785) werden die vorselektierten Signale der UHF-VHF-
Fernsehbereiche durch einen gemeinsamen Vorstufentransistor
vorverstärkt. Dem Vorverstärkertransistor ist ein nach Art
eines lambda-halbe-Resonzkreises aufgebauter Schwingkreis
nachgeschaltet, der am Hochpunkt eingespeist und über eine
Leitungsinduktivität und eine abstimmbare Kapazität gegen
Masse geschaltet ist. Parallel zur abstimmbaren Kapazität
liegt eine Abgleichspule in Serie mit einer Schaltdiode
gegen Masse. Parallel zur Schaltdiode liegt auch eine Spule,
die bei gesperrter Schaltdiode die Resonanzfrequenz des
Resonanzkreises in den VHF-Bereich I schiebt. Der Resonanzkreis bildet zusammen mit einem in gleicher Weise aufgebauten und damit gekoppelten gleichartigen Resonanzkreis ein
Bandfilter. Vom Hochpunkt des sekundärseitigen Resonanzkreises sowie von einer Anzapfung der Spule für den VHF-Bereich I des Sekundärkreises führt je eine Leitung zum Eingang einer von einem separaten Oszillator gesteuerten und
für alle drei Frequenzbereiche ausgelegten Mischstufe. Die

0128532

16.02.1983
Bt/ub

Abgleichspule ist im Resonanzkreis jeweils so bemessen, daß der Resonanzkreis gleichzeitig im UHF wie im VHF-Bereich III schwingt. Daher wird am Hochpunkt das selektierte Signal des VHF-Bereichs III wie das Signal des UHF-Bereichs ausgekoppelt. Von Nachteil ist bei dieser Schaltungsnaordnung, daß mit den zur Verfügung stehenden Kapazitätsdioden eine Abstimmung des gesamten VHF-Bereichs I über den Frequenzbereich von 50 bis 85 Mhz mit Rückstand auf die übrigen durchzustimmenden Frequenzbereiche praktisch nicht erreicht werden kann.

Der Erfindung liegt die Aufgabe zugrunde, bei einer Abstimmschaltung gemäß dem Oberbegriff des ersten Patentanspruchs Maßnahmen zu treffen, durch die mit einfachen Mitteln ein erweiterter Abstimmbereich in den Frequenzbändern der VHF-Bereiche I und III erreicht wird.

Die Lösung dieser Aufgabe erfolgt gemäß der Erfindung durch die kennzeichnenden Merkmale des ersten Patentanspruchs.

Bei einem Aufbau einer Abstimmschaltung gemäß der Erfindung ist bei geschlossenem Schalter die weitere Kapazität unwirksam. Der Resonanzkreis wird dann als lambda-halbe-Resonanzkreis für den UHF-Bereich betrieben. Durch Öffnen des Schalters wird dagegen die Masseverbindung, welche die zusätzliche Abstimmkapazität überbrückt hat, aufgehoben. Hierdurch wird auch die in Serie mit der weiteren Abstimmkapazität liegende Induktivität wirksam, wodurch der Frequenzbereich in ein niedrigeres Frequenzband verschoben wird. Gleichzeitig wird jedoch die im Resonanzkreis vorhandene Abstimmkapazität durch die weitere Abstimmkapazität unterstützt, wobei durch die Serienschaltung der weiteren Abstimmkapazität mit der zugeschalteten Spule der erhöhte Abstimmbereich

TEG-83/02

16.02.1983
Bt/ub

erzielt wird. Die weitere Abstimmkapazität läßt sich dadurch an den Fußpunkt des erweiterten Resonanzkreises legen, wo ihr Kapzitätsvariationsbereich optimal ausgenutzt werden kann. Bei diesem Aufbau kann außerdem die im UHF-Bereich selektierte HF-Energie am Hochpunkt des Resonanzkreises ausgekoppelt und einer selbstschwingenden UHF-Mischstufe zugeführt werden, während die VHF-Signale über der weiteren Abstimmkapazität auskoppelbar und einer fremdgesteuerten VHF-Mischstufe zugeführt werden kann. Die UHF-Mischstufe kann dann als Oszillator für die VHF-Bereiche umgeschaltet werden. Die getrennte Auskopplung hat dann auch den Vorteil, daß eine optimale Anpassung in den einzelnen Frequenzbereichen an die Eingangsimpedanzen der Mischstufen erfolgen kann. Die Ausnutzung des VHF-Mischstufentransistors als ZF-Verstärker für das UHF-ZF-Signal wird dadurch nicht beeinträchtigt. Die mit der weiteren Abstimmkapazität in Serie liegende Induktivität kann gemäß einer vorteilhaften Ausgestaltung aus einer Spule für den VHF-Bereich III und einer dazu in Serie liegenden Spule für den VHF-Bereich I gebildet sein, wobei die Spule für den VHF-Bereich I mit einem weiteren Schalter kurzschließbar ist.

Weitere vorteilhafte Ausgestaltungen der Erfindung sind in den übrigen Ansprüchen angegeben.

Die Erfindung ist nachfolgend anhand der Schaltungsskizze eines Ausführungsbeispiels näher erläutert.

Ein MOS-FET-Vorstufentransistor 1 verstärkt die an seinem Gate 2 anstehenden UHF- bzw. VHF I-bzw. VHF III-Signale und speist sie über einen Koppelkondensator 3 in den Hochpunkt eines Schwingkreises ein, der nach Art eines lambda-halbe-Resonanzkreises aufgebaut ist. Zwei gleich aufgebaute derartige Resonanzkreise 4, 5 bilden durch geeignete Kopplung ein Bandfilter. Die Resonanzkreise bestehen je aus einer Leitungsinduktivität 6 mit einer in Serie geschalteten veränderbaren Induktivität für den Abgleich am unteren Frequenzbereichende des UHF-Bereichs und einer gegen Masse geschalteten Abstimmkapazität 8, die als Kapazitätsdiode mit veränderbarer Sperrschichtkapazität ausgebildet ist. An den Verbindungspunkt der Induktivität 7 mit der Abstimmkapazität 8 ist eine Abgleichspule 9 für den Abgleich am oberen Frequenzende des UHF-Bereichs angeschlossen. Der zweite Anschluß der Abgleichspule 9 liegt in Serie mit einem Abblockkondensator 10 über eine als Schalter wirkende Schaltdiode 11 an Masse. Bei UHF-Betrieb ist die Schaltdiode 11 in den leitenden Zustand geschaltet, so daß die Abgleichspule 9 hochfrequenzmäßig parallel zur Abstimmkapazität 8 liegt. In diesem Fall bildet die Schaltdiode 11 zugleich einen Kurzschluß für eine Induktivität 12, 13, die über eine weitere Abstimmkapazität 14 ebenfalls gegen Masse geschaltet ist. Wird der Kurzschluß über die Schaltdiode 11 aufgehoben, dann bildet die Abstimmkapazität 14 zusammen mit der Spule 12 und der weiteren Spule 13 eine zusätzliche Induktivität im jeweiligen Resonnanzkreis 4 bzw. 5, die so bemessen sind, daß die Resonanzfrequenz im VHF-Bereich I liegt. Wird die Spule 13 dabei durch eine zusätzliche Schaltdiode 15 kurzgeschlossen, dann ist die Bemessung so getroffen, daß die Resonanzfrequenz im VHF-Bereich III liegt. Die Kopplung zwischen dem primären Resonanzkreis 4 und dem sekundären Resonanzkreis 5 des Bandfilters erfolgt im UHF-Bereich eine durch Flußpunktkopplung. Im VHF-Bereich I sind die Spulen 13 räumlich so eng benachbart, daß eine ausreichende Kopplung eintritt, während für den VHF-Bereich III am Fußpunkt der weiteren Abstimmkapazität 14

0128532

eine gemeinsame Fußpunktinduktivität 17 in die Verbindung
nach Masse eingeschaltet ist. Im übrigen sind die Abstimmkapazitäten 8, 14 gleichstrommäßig jeweils über die Induktivitäten
9, 12, 13 parallel geschaltet. Die Spule 13 für den VHF-
Bereich I ist in Serie zwischen die Abgleichspule 9 und die
Spule 12 für den VHF-Bereich III geschaltet, damit die
Schaltungskapazität nicht unmittelbar parallel zur Abstimmkapazität 14 liegt und deren Abstimmbereich unnötig einschränkt. Dabei ist die weitere Schaltdiode 15 bei VHF-Bereich III-Betrieb in Sperrichtung zusätzlich elektrisch vorgespannt, so daß ihre Schaltkapazität auf ein Minimum reduziert wird. Hierdurch ist die Parallelkapazität auch zur
Spule 13 bei gesperrter Schaltdiode 15 sehr klein, so daß
der Durchstimmbereich praktisch nicht beeinflußt wird. Die
Schaltdiode ist im übrigen auch bei UHF-Betrieb in den leitenden Zustand geschaltet, um störende Saugstellen im Durchstimmbereich zu vermeiden.

Die Auskopplung der HF-Energie im UHF-Bereich erfolgt am
Hochpunkt des sekundären Schwingkreises 5 über einen Koppelkondensator 18. Getrennt davon wird die HF-Energie in den
VHF-Bereichen am Verbindungspunkt der Spule 12 mit der
weiteren Abstimmkapazität 14 im Sekundärkreis 5 über einen
Koppelkondensator 19 ausgekoppelt. Durch die getrennte Auskopplung der HF-Energie kann trotz der kombinierten Ausführung des UHF-VHF-Bandfilters 4,5 für den UHF-Bereich eine
selbstschwingende Mischstufe 20 angewandt werden. Dagegen
kann im VHF-Bereich die HF-Energie unmittelbar einer fremdgesteuerten Mischstufe 21 zugeführt werden, die im UHF-
Betrieb als nachfolgender ZF-Verstärker verwendet werden
kann. Bei VHF-Betrieb kann dagegen aber auch der VHF-Oszillator durch Umschalten der UHF-Mischstufe realisiert werden.
Hierdurch kann für die VHF-Mischstufe 21 ein Transistor
verwendet werden, insbesondere ein MOS-FET, der für den
VHF-Frequenzbereich eine hohe Eingangsimpedanz, für die UHF-Frequenz jedoch einen sehr niedrigen Widerstand aufweist.
Die gegebenenfalls über den Koppelkondensator 19 ausgekoppelten
UHF-Frequenzen werden dadurch bei UHF-Betrieb durch die in
diesem Fall sehr geringe Eingangsimpedanz der VHF-Mischstufe
stark gedämpft. Die Einspeisung der Steuerspannungen für die
Kapazitätsdioden 8, 14 bzw. die Schaltströme für die Schaltdioden 11, 15 erfolgt jeweils über ohmsche Entkopplungs-
und Strombegrenzungswiderstände, während die gleichstrommäßige
Entkopplung durch Trennkondensatoren erfolgt.

0128532

Bt/ub

TELEFUNKEN electronic GmbH
Frankfurt/Main

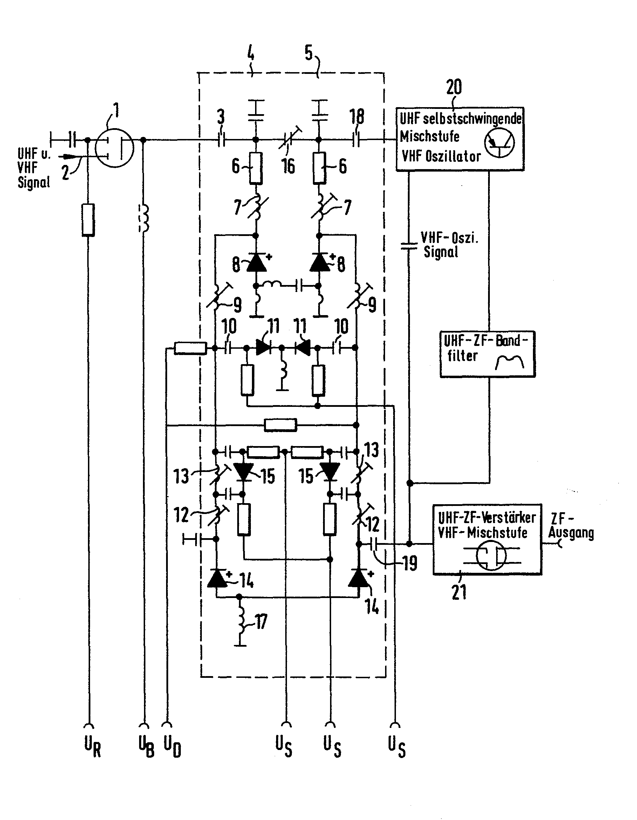

Patentansprüche

Abstimmschaltung für die Frequenzbereiche UHF und VHF mit einem nach Art eines lambda-halbe-Resonanzkreises aufgebauten Schwingkreis, bei dem parallel zu einer Abstimmkapazität eine Abgleichspule für das obere Frequenzbandende des UHF-Bereichs über einen Schalter an Masse geschaltet ist und parallel zum Schalter wenigstens eine Induktivität liegt, die bei geöffnetem Schalter die Resonanzfrequenz des Resonanzkreises in den VHF-Bereich schiebt, dadurch gekennzeichnet, daß in Serie mit der Induktivität (12, 13) eine weitere Abstimmkapazität (14) liegt.

2. Abstimmschaltung nach Anspruch 1, dadurch gekennzeichnet, daß der Hochpunkt des lmbda-halbe-Resonanzkreises (4, 5) an eine selbstschwingende Mischstufe (20) für den UHF-Bereich und der Verbindungspunkt der Induktivität (12) mit der weiteren Abstimmkapazität (14) an eine fremdgesteuerte Mischstufe (21) für die VHF-Bereiche angeschaltet ist.

3. Abstimmschaltung nach Anspruch 1 oder 2, dadurch gekennzeichnet, daß die Abstimmkapazitäten (8, 14) gleichstrommäßig parallel geschaltet sind.

4. Abstimmschaltung nach Anspruch 1 oder einem der folgenden,

16.02.1983
Bt/ub

dadurch gekennzeichnet, daß der Schalter (11) nur bei UHF-Betrieb geschlossen ist und daß die Induktivität aus einer Spule (12) für den VHF-Bereich III und einer in Serie dazu liegenden Spule (13) für den VHF-Bereich I gebildet ist, die mit einem weiteren Schalter (15) kurzschließbar ist.

5. Abstimmschaltung nach Anspruch 1 oder einem der folgenden, dadurch gekennzeichnet, daß die Schalter (11, 15) Schaltdioden sind.

6. Abstimmschaltung nach Anspruch 2 oder einem der folgenden, dadurch gekennzeichnet, daß die selbstschwingende Mischstufe (20) bei VHF-Betrieb als Oszillator für den VHF-Bereich geschaltet ist.

7. Abstimmschaltung nach Anspruch 2 oder einem der folgenden, dadurch gekennzeichnet, daß zwei Resonanzkreis (4,5) zu einem Bandfilter gekoppelt sind und daß die Auskopplung der HF-Energie nur am Sekundärkreis (5) erfolgt.

8. Abstimmschaltung nach Anspruch 7, dadurch gekennzeichnet, daß die weiteren Abstimmkapazitäten (14) der Bandfilterkreise (4,5) über eine gemeinsame Fußpunktinduktivität (17) an Masse geschaltet sind.

9. Abstimmschaltung nach Anspruch 2 oder einem der folgenden, daß in der fremdgesteuerten Mischstufe (21) ein Transistor angeordnet ist, dessen Eingangswiderstand bei VHF-Frequenzen wesentlich höher als bei UHF-Frequenzen ist.

10. Abstimmschaltung nach Anspruch 4 oder einem der folgenden, dadurch gekennzeichnet, daß die Spule (13) für den UHF-Bereich I in Serie zwischen die Abgleichspule (9) und die

0128532

Spule (12) für den VHF-Bereich III geschaltet ist.

11. Abstimmschaltung nach Anspruch 4 oder einem der folgenden, dadurch gekennzeichnet, daß die weitere Schaltdiode (15) bei VHF-Bereich III - Betrieb in Sperrichtung elektrisch vorgespannt ist.

UHF u.
VHF
Signal

UHF selbstschwingende
Mischstufe
VHF Oszillator

20

VHF-Oszi.
Signal

UHF-ZF-Bandfilter

UHF-ZF-Verstärker
VHF-Mischstufe

ZF-
Ausgang

$U_R$  $U_B$  $U_D$  $U_S$  $U_S$  $U_S$